# EUROPÄISCHE PATENTANMELDUNG

(11) **EP 0 548 817 A2**
(43) Veröffentlichungstag der Anmeldung: **30.06.1993**
(21) Anmeldenummer: 92121527.3
(22) Anmeldetag: 17.12.1992
(51) Int. Cl.: G01R 31/02

(54) **Verfahren und Vorrichtung zum Überprüfen der Isolation von isolierten elektrischen Leitern sowie zur Längenvermessung von Isolationsfehlern**

(30) Priorität: 20.12.1991 DE 4142373
(71) Anmelder: SIEMENS AKTIENGESELLSCHAFT, D-80333 München (DE)
(72) Erfinder: Heuring, Wolfgang Dr., W-8520 Erlangen (DE); Besslein, Bernd Dr., W-8520 Erlangen (DE)

(57) **Zusammenfassung**

Derartige Leiter, die wenigstens eine Ader bilden, werden an hintereinander liegenden Sonden, die jeweils Kondensatoren mit einem Leiterstück als Gegenpol bilden, vorbeibewegt. Dabei ist gemäß der Erfindung die eine Sonde bevorzugt, wodurch beim Ein- und Auslaufen von Fehlern in der Isolation bei den nicht bevorzugten Sonden jeweils nur kurzzeitige Überschläge als sogenanntes Funkenziehen erfolgen, während an der bevorzugten Sonde Überschläge genau in der Durchlaufzeit erfolgen, die exakt der Länge des vorbeibewegten Isolationsfehlers entspricht. Bei der zugehörigen Einrichtung ist genau eine Meßelektrode (HE) vorhanden, der wenigstens eine Abschirmelektrode (EE, AE) zugeordnet ist, wobei die Meßelektrode (HE) und die Abschirmelektroden (EE, AE) ein Elektrodensystem (10) bilden, bei dem die Meßelektrode (HE) geometrisch und/oder elektrisch bevorzugt ist. Vorzugsweise ist die Meßelektrode (HE) zwischen zwei Abschirmelektroden (EE, AE) angeordnet.

## Beschreibung

Die Erfindung bezieht sich auf ein Verfahren zum Überprüfen der Isolation von isolierten elektrischen Leitern, die wenigstens eine Ader haben, sowie zur Längenvermessung von Isolationsfehlern. Daneben bezieht sich die Erfindung auch auf die zugehörige Vorrichtung zur Erkennung und Klassifizierung von Isolationsfehlern in Adern mit mehreren an Hochspannung liegenden Elektroden, an denen die Ader vorbeibewegt wird und die bei Auftreten eines Isolationsfehlers über einen Funken kurzgeschlossen werden.

Zur Prüfung von Adern auf isolationsfehler wird üblicherweise Hochspannung zwischen einer geeignet ausgebildeten Elektrode und der Ader angelegt. Liegt ein Isolationsfehler vor, so treten wenn der Fehler in die Nähe der Elektrode kommt, Durchschläge auf, die von einer Auswerteelektronik registriert werden können. Die Adern werden im allgemeinen mit hohen Geschwindigkeiten, d.h. bis etwa 1000 m/min an der Elektrode vorbeibewegt. Wesentlich ist dabei, ein geeignetes Auflösungsvermögen für die Fehlerdiskriminierung zu erreichen.

Es sind bereits Verfahren und zugehörige Vorrichtungen zur Erkennung und Klassifizierung von Isolationsfehlern in Adern bekannt. Beispielsweise in der EP-A-0 394 525 läuft ein Leiter berührungslos axial durch wenigstens zwei hintereinander liegende ringförmige Sonden, welche mittels wenigstens einer Spannungsquelle derart aufgeladen sind, daß bei Fehlern in der Isolation der Kondensator von einem Durchschlagstrom kurzgeschlossen wird. Durch Erfassen der Überschläge und deren Auswertung an den von den einzelnen Sonden gebildeten Kondensatoren werden dabei jeweils ortsspezifische Signale in Korrelation mit dem Vorschub des Leiters gewonnen. Durch logische Verknüpfung dieser ortsspezifischen Signale werden dann von den Einzelkondensatoren Prüfgrößen für die Längenausdehnung der Isolationsfehler abgeleitet. Weiterhin ist aus der älteren deutschen Patentanmeldung P 40 34 591.2 ein Verfahren dieser Art bekannt, bei dem die Sonden speziell durch identische Rollen gebildet werden, an denen der Leiter unter Berührung vorbeiläuft. Ziel ist dabei, die benötigten Hochspannungen klein zu halten und das Auflösungsvermögen für die Fehlerdiskriminierung zu verbessern.

Es hat sich gezeigt, daß bei obigen Verfahren und insbesondere bei den Prüfgeräten, die in der Praxis verwendet werden, im allgemeinen die Länge der vorhandenen Fehler ungenau angegeben wird. Erklärt wird dies dadurch, daß im Falle des Durchschlages der Funke noch eine Zeitlang nachbrennt, was als "Funkenziehen" bezeichnet wird. Weiterhin wird häufig wegen der Länge der Elektrode, insbesondere bei den erwähnten Rohrelektroden oder auch bei sogenannten Kugelketten ein und derselbe Fehler mehrfach registriert.

In der Praxis hat sich bei Messungen mit bekannten Prüfgeräten gezeigt, daß die registrierten Fehler häufig viel kleiner sind als gemessen wurde. Es ist aber wünschenswert, die Fehlergröße genau zu kennen.

Insbesondere dann könnten die Fehlerlängen genauer bestimmt werden, wenn das Vor- und Nachzünden des Funkens verkürzt oder auch vom eigentlichen Zündvorgang unterschieden wurde. In der Praxis gibt es allerdings noch kein Gerät, welches das "Funkenziehen" unter Kontrolle bringt.

Aufgabe der Erfindung ist es daher, ein Verfahren und die zugehörige Vorrichtung anzugeben, mit denen bei der Isolationsprüfung von Adern Fehlerlängen mit größerer Genauigkeit als bisher bestimmt werden können.

Die Aufgabe wird bei einem Verfahren der eingangs genannten Art durch die Abfolge folgender Verfahrensmerkmale gelöst:
- Die Ader wird an wenigstens zwei hintereinander liegenden Sonden, die jeweils Kondensatoren mit einem Leiterstück als Gegenpol bilden und von denen eine Sonde bevorzugt ist, vorbeibewegt,
- dabei sind die Sonden derart elektrisch aufgeladen, daß bei Fehlern in der Isolation der Ader der von der einzelnen Sonde und dem jeweiligen Leiterstück gebildete Kondensator von einem Durchschlagstrom kurzgeschlossen wird,
- beim Ein- und Auslaufen von Fehlern in die Isolation erfolgen bei den nicht bevorzugten Sonden jeweils nur kurzzeitige Überschläge als Funkenziehen, während an der bevorzugten Sonde die Überschläge genau in der Durchlaufzeit erfolgen, die der Länge des vorbeibewegten Isolationsfehlers entspricht,
- durch Erfassen der Überschläge der bevorzugten Sonde und deren Auswertung werden ortsspezifische Signale in Korrelation mit dem Vorschub der Ader gewonnen,
- diese ortsspezifischen Signale geben eine unmittelbare Aussage über die Längenausdehnung des Isolationsfehlers.

Bei der erfindungsgemäßen Vorrichtung ist für obigen Zweck genau eine Meßelektrode vorhanden, der wenigstens eine Abschirmelektrode zugeordnet ist. Dabei bilden die Meßelektrode und die Abschirmelektrode ein Elektrodensystem, bei dem die Meßelektrode geometrisch und/oder elektrisch bevorzugt ist. Sofern nur eine Abschirmelektrode vorhanden ist, befindet sich diese in Abzugsrichtung hinter der Meßelektrode. Vorzugsweise sind aber zwei oder mehr Abschirmelektroden vorhanden, zwischen denen sich die geometrisch und elektrisch bevorzugte Meßelektrode befindet.

Das erfindunggemäße Verfahren und die zugehörige Vorrichtung unterscheiden sich vom Stand der Technik durch zwei wesentliche Maßnahmen: Einerseits wird beim Ein- und Auslaufen des Fehlers zur Hochspannungselektrode hin bzw. von der Elektrode weg das "Funkenziehen" jeweils durch eine Abschirmelektrode übernommen und damit aufgefangen. Es kann also somit das "Funkenziehen" vom eigentlich interessierenden Zündvorgang an der Meßelektrode diskriminiert werden. Damit wird andererseits die Messung der Fehlerlänge unmittelbar mittels einer solchen Elektrode durchgeführt, die exakt außerhalb störender Zündvorgänge mißt und dafür gegenüber den Abschirmelektroden geometrisch und elektrisch bevorzugt ist.

Während also bei den Verfahren des Standes der Technik mit jeweils gleichberechtigten Elektroden gearbeitet wird, bildet nunmehr die Meßelektrode eine bevorzugte Hauptelektrode. Es hat sich gezeigt, daß mit einem solchen Verfahren und der zugehörigen Vorrichtung die Genauigkeit der Fehlervermessung erheblich verbessert wird. In der Praxis ist es gelungen, bei Abzugsgeschwindigkeiten von beispielsweise 1000 m/min Fehler mit einer Genauigkeit von - 0 bis + 5 mm oder besser zu messen. Dabei kann berührungslos oder auch berührend gemessen werden.

Bei der erfindungsgemäßen Vorrichtung ist dem Elektrodensystem, an das die Hochspannung angelegt wird, eine Schaltungsanordnung zur Erfassung und Auswertung des Durchschlagstromes zugeordnet. Das Elektrodensystem besteht vorzugsweise aus drei parallel angeordneten, gegeneinander isolierten Metallblechen. Wesentlich ist dabei, daß der Abstand der Bleche möglichst klein ist und das mittlere Blech hinsichtlich der vorbeilaufenden Ader gegenüber den äußeren Blechen hervorgeht. Somit wird die geometrische Bevorzugung erreicht. Durch geeignete Auslegung der Schaltungsanordnung kommt hierzu gleichermaßen noch eine elektrische Bevorzugung hinzu.

Weitere Einzelheiten und Vorteile der Erfindung ergeben sich aus der nachfolgenden Figurenbeschreibung eines Ausführungsbeispiels anhand der Zeichnung. Es zeigen jeweils in schematischer Darstellung
- Figur 1: die Ansicht von vorne auf einen durchlaufenden Leiter mit zugehörigem Elektrodensystem zur Erfassung von Isolationsfehlern
- Figur 2: eine perspektivische Darstellung des Elektrodensystems und
- Figur 3: die elektrische bzw. elektronische Auslegung der Schaltung zur Erfassung der Isolationsfehler.

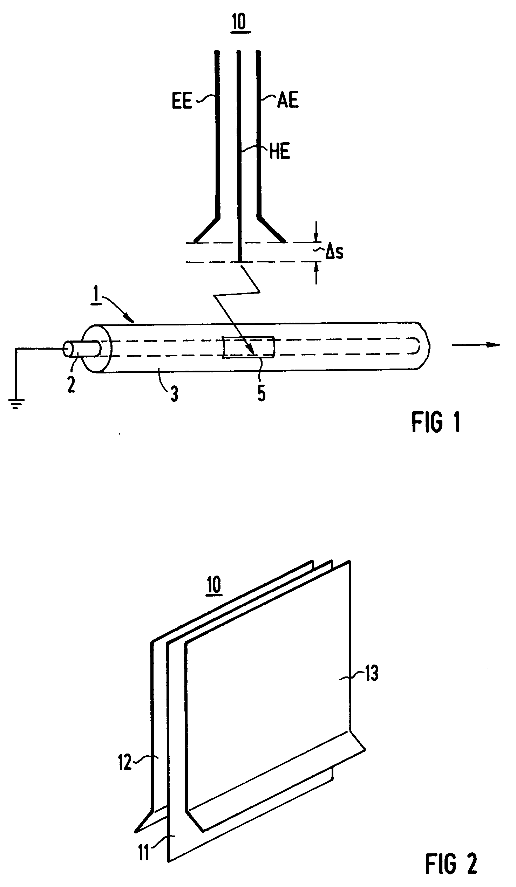

In Figur 1 ist eine Ader mit 1 bezeichnet, die aus einem metallischen Leiter 2, beispielsweise aus Kupfer und einer umhüllenden Isolationsschicht 3 besteht. Ein in der Isolationsschicht 3 vorhandener Fehler ist mit 5 bezeichnet. Für die Praxis, insbesondere für die bestimmungsgemäße Weiterverwendung der automatisiert aufextrudierten Isolationsschicht, ist es entscheidend, die Länge etwaiger Isolationsfehler möglichst genau zu erfassen. Dabei kommt es darauf an, zwischen sogenannten kurzen Fehlern (KF) und langen Fehlern (LF) zu diskriminieren. Speziell lange Fehler bedürfen vor der bestimmungsgemäßen Weiterverwendung der Ader einer Reparatur.

In Figur 1 ist der Ader 1, deren Abzugsrichtung gemäß dem axialen Pfeil von links nach rechts erfolgt, ein Elektrodensystem 10 zugeordnet. Während die Ader 1 mit ihrem metallischen Leiter 2 auf Erdpotential liegt, ist das Elektrodensystem an Hochspannung angeschlossen.

Im einzelnen besteht das Elektrodensystem 10 aus drei parallel angeordneten, miteinander verschraubten Metallblechen 11, 12, 13. Die Bleche 11 bis 13 haben beispielsweise je eine Fläche von 20 mm x 20 mm und sind durch (nicht-dargestellte) Kunststoffscheiben elektrisch gegeneinander isoliert. Der Abstand der Bleche 11 bis 13 ist dabei möglichst klein gehalten, beispielsweise kleiner als 1 mm. Das mittlere Blech 11 ist etwa 1 mm länger als die äußeren Bleche 12 und 13. Auf der Seite des Elektrodensystems 10, auf der die Ader 1 vorbeigezogen wird, steht demzufolge das mittlere Blech 11 um 4 s ≈ 1 mm hervor und liegt damit um diese Strecke näher an der zu prüfenden Ader 1. Die beiden äußeren Bleche 12 und 13 sind auf dieser Seite der Elektrodenanordnung 10 vom mittleren Blech 11 weggebogen. Die Ader 1 wird in möglichst geringem Abstand am Elektrodensystem 10, an dem die Hochspannung anliegt, vorbeigezogen. Dadurch, daß der Leiter 2 der Ader 1 mit Masse verbunden ist, wird zwischen den an Hochspannung liegenden Blechen und dem Leiter jeweils ein Kondensator gebildet. Beim Vorliegen von Isolationsfehlern erfolgen in den jeweils gebildeten Kondensatoren Durchschläge.

Durch die Verwendung der drei Elektroden 11 bis 13 ist gewährleistet, daß die erste Elektrode 12, die nachfolgend als Eingangselektrode EE bezeichnet wird, den Funken solange übernimmt, bis der Fehler in die Nähe der mittleren Elektrode 11 kommt. Da die mittlere Elektrode bevorzugt ist, wird sie nachfolgend als sogenannte Hauptelektrode HE bezeichnet: Nach einem kurzen Vorzünden der EE wandert der Funke zur HE. Die HE brennt nun, während die EE erlischt. Hat das Ende eines Fehlers die HE passiert, so übernimmt die dritte Elektrode 13, die als Ausgangselektrode AE bezeichnet wird, den Funken während des Nachbrennvorgangs.

Da die HE im Vergleich zu den Nachbarelektroden 12 und 13 näher an die Ader 1 herangeführt ist, können nunmehr lange Fehler einwandfrei als solche identifiziert werden. Kommt nämlich ein langer Fehler, muß nach dem Vorzünden während der gesamten Zeit die HE brennen und erst dann, wenn das Ende des Fehlers passiert, kann die AE das Zünden übernehmen. Dadurch ist gewährleistet, daß nicht etwa beim Vorbeiziehen eines längeren Fehlers die HE erlischt und eine der Außenelektroden (EE oder AE) bereits zündet und die HE kurze Zeit später weder anspringt. Letzteres hätte zur Folge, daß anstelle eines langen Fehlers zwei oder mehrere kürzere Fehler angezeigt werden.

Um letzteren Effekt sicher auszuschließen, muß also die HE so stark bevorzugt sein, daß die Wahrscheinlichkeit für ein Fehlzünden verschwindend gering ist. Dies wird dadurch erreicht, daß gemäß Figur 1 die HE näher als die EE und die AE an die Ader 1 herangeführt ist und daß außerdem die Außenelektroden von der HE weggebogen sind. Insbesondere dadurch ergibt sich eine geometrische Bevorzugung der mittleren Elektrode 11 gegenüber den äußeren Elektroden 12 und 13.

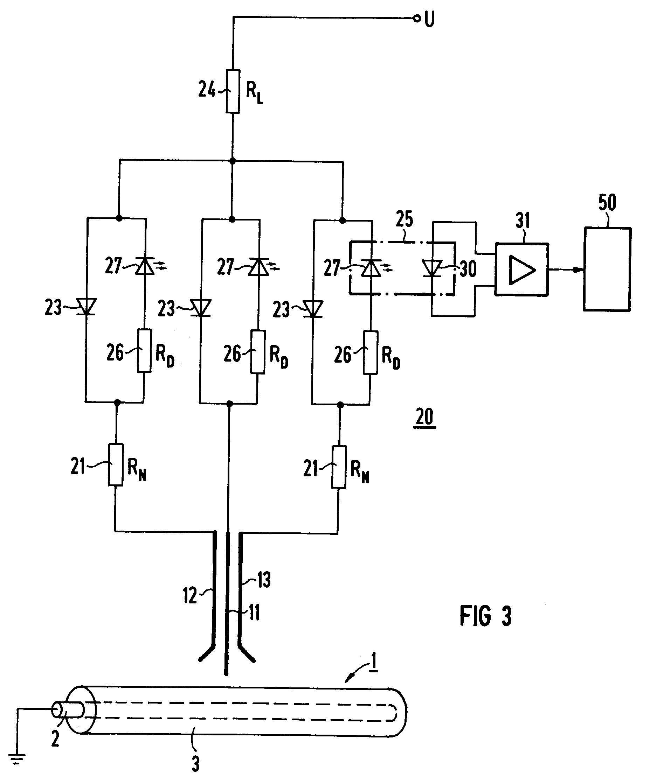

In Figur 3 ist dem beschriebenen Elektrodensystem 10 eine Schaltungsanordnung 20 zur Erfassung und Auswertung der Durchschlagströme zugeordnet. In den Zweigen der beiden Hilfselektroden 12 und 13 sind je ein Widerstand 21 mit Widerstandswert R_{N} eingeschaltet. Die darüber abfallenden Signale und das Signal der Hauptelektrode 11 gelangen über Optokoppler zu einer Auswerteeinrichtung mit einem Personalcomputer 50. Die den drei Elektroden 11, 12 und 13 zugeordneten elektrischen Kreise bestehen je aus parallelgeschalteten Versorgungs- und Auswertezweigen. Dabei wird jeweils im Versorgungszweig über eine Sperrdiode 23 die Hochspannung von einer nicht im einzelnen dargestellten Hochspannungsquelle über einen Vorwiderstand 24 mit Widerstandswert R_{L} an das Elektrodensystem 10 gelegt. Im Parallelzweig gelangt das Kurzschlußsignal jeweils über Optokoppler galvanisch entkoppelt zur Auswerteeinheit mit dem Personalcomputer 50. Hierfür sind senderseitig jeweils Sendedioden 27 mit vorgeschaltetem Widerstand 26 mit Widerstandswert R_{D} und empfängerseitig entsprechende Empfangsdioden 30 mit nachgeschaltetem Verstärker 31 vorhanden, was anhand eines einzigen Detektionskreises angedeutet ist. Die so detektierten Signale können nach Digitalisierung softwaremäßig ausgewertet werden.

Mittels des Widerstandes 24 mit Widerstandswert R_{L} von einigen MΩ wird erreicht, daß der Funke während des Durchschlages nicht zu stark hin und her springt und unerwünschterweise statt zur HE zu zünden auf eine der Außenelektroden gelangt, sondern als Durchschlagstrom gedämpft ist. Dadurch brennt der Funke ruhiger. Weiterhin bewirkt der zusätzliche Widerstand 21 in dem Kreis der Außenelektroden 12 und 13 zusätzlich, daß die HE elektrisch bevorzugt wird. Insbesondere wird erreicht, daß dann, wenn nach dem Entladen des Gesamtelektrodensystems das System wieder aufgeladen wird, die Spannung an den Hilfselektroden aufgrund des zusätzlichen Widerstandes R_{N} der Spannung an der HE hinterherläuft. Befindet sich nun ein Isolationsfehler zwischen einer Außenelektrode und der HE, so wird wegen der etwas höheren Spannung der Funke beim gleich folgenden Durchschlag zur HE zünden. Damit ist also die HE weiter elektrisch bevorzugt.

Aufgrund der elektrischen und geometrischen Bevorzugung der Hauptelektrode (HE) ergibt sich, daß beim Vorbeilaufen eines Fehlers an der Elektrodenanordnung 10 der erwünschte Zündablauf sichergestellt wird: Beim Einlaufen des Fehlers zündet zunächst die EE. Sobald sich die Fehlerfront zwischen EE und HE befindet übernimmt die HE den Funken. Erst wenn das Fehlerende die HE passiert hat, wird der Funke von der AE übernommen.

Mit der beschriebenen Anordnung werden die drei Zündvorgänge, nämlich das Vorzünden zur EE, das Zwischenzünden zur HE und das Nachzünden zur AE sicher voneinander getrennt. Es brennt immer nur eine Elektrode und zwar in der richtigen Reihenfolge, d.h. im zeitlichen Ablauf: EE-HE-AE. Das "Funkenziehen" läßt sich somit eindeutig vom Meßvorgang diskriminieren.

Durch die Stromdetektion mittels Optokoppler, bei denen die Sender und Empfänger über Lichtwellenleiter miteinander verbunden sind, lassen sich die Meß- und Auswerteelektronik räumlich gut voneinander trennen. Dabei können auch elektromagnetische Felder, die im Zusammenhang mit den elektrischen Durchschlägen auftreten, leichter abgeschirmt werden. Jeder Elektrode ist ein eigener Stromdetektionskreis 25 zugeordnet, wobei Figur 3 speziell den der Ausgangselektrode 13 zugeordneten Detektionskreis 25 zeigt.

Jeder Detektionskreis 25 besteht aus dem Optokoppler 27, der seriell mit dem Widerstand 26 mit Widerstandswert R_{D} von einigen KΩ zur Dämpfung von Schwingungen verbunden ist, und aus der zu den Bauelementen 26 und 27 parallelgeschalteten Diode 23, die in umgekehrter Richtung wie der Optokoppler stromdurchlässig ist. Da bei den Außenelektroden zusätzlich zwischen dem Elektrodenblech 12 und 13 und dem Stromdetektionskreis der Widerstand 21 mit Widerstandswert R_{N} von einigen 10 KΩ geschaltet ist, ergibt sich deutlich die erwünschte elektrische Benachteiligung der jeweiligen Außenelektrode beim Wiederaufladen nach einem Durchschlag. Gemäß Figur 3 bilden die drei parallelen Elektrodenkreise ein

Widerstandsnetzwerk, das mit der Hochspannungsquelle über den Widerstand 24 mit Widerstandswert R_{L} verbunden ist, wodurch der Durchschlagstrom begrenzt ist. Findet ein Durchschlag statt, so fließt ein Strom von der Ader 1 auf die gerade zündende Elektrode und von dort über den zugehörigen Optokoppler und den Lastwiderstand R_{L} zur Hochspannungsquelle, da gemäß Figur 3 die Hochspannungsquelle negativ gepolt ist. Zur Entladung der beiden anderen Elektroden fließt negative Ladung über die jeweiligen zum Optokoppler antiparallel geschalteten gewöhnlichen Dioden 23 und die zündende Elektrode zur Ader 1.

Die Sendediode 27 jedes Optokopplers gibt einen Lichtimpuls ab, der im jeweils zugehörigen Empfänger 30 einen Photostrom erzeugt. Jeder Empfänger 30 ist mit dem hochohmigen Eingang des Verstärkers 31 verbunden. Fließt ein Photostrom, so fällt am Verstärkereingang eine Spannung ab, die verstärkt, von einem nicht-dargestellten A/D-Wandler digitalisiert und dann in den Rechner 50 eingelesen wird. Bei bekannter Abzugsgeschwindigkeit, die mit üblichen Geräten wie einem Millimeterrad gemessen wird, lassen sich anhand des zeitlichen Verlaufs der Spannungssignale die Längen der Fehler 5 längs der Ader 1 errechnen, wobei jetzt nur noch die Signale der Hauptelektrode maßgebend sind.

Bei der anhand der Figuren beschriebenen Vorrichtung ist die Hauptelektrode HE als Meßelektrode symmetrisch zwischen der Eingangselektrode EE und der Ausgangselektrode AE als Abschirmelektrode angeordnet. Bei langsamen Abzugsgeschwindigkeiten der zu prüfenden Leitung kann eine einzige Abschirmelektrode genügen, sofern sie in Abzugsrichtung hinter der der Meßelektrode angeordnet ist. Es kann auch sinnvoll sein, eine Mehrzahl von Abschirmelektroden mit einer zu beiden Seiten der Meßelektrode symmetrischen oder unsymmetrischen Konfiguration vorzusehen, wobei die Abschirmelektroden - jeweils von der Meßelektrode ausgehend - hinsichtlich ihrer geometrischen und elektrischen Bevorzugung nach außen abgestuft sind.

Bei allen erfindungsgemäßen Vorrichtungen kann sowohl mit Gleichspannung als auch mit Wechselspannung gearbeitet werden. Bei Verwendung von Gleichspannung spielt es keine Rolle, ob die Elektroden gegenüber der Ader positiv oder negativ geladen sind. Die Stromdetektionsschaltungen der einzelnen Elektroden sind dann jedoch so auszulegen, daß die Sendedioden 27 der Optokoppler 25 beim Zünden der zugehörigen Elektrode in Durchlaßrichtung und die Diode 23 in Sperrichtung geschaltet sind.

Die Hochspannung für die beschriebene Vorrichtung wird so groß gewählt, daß die Durchbruchfeldstärke in Luft überschritten ist. Dabei wirkt es sich aber nicht nachteilig auf die Meßgenauigkeit aus, wenn die angelegte Spannung deutlich höher ist als die Durchbruchspannung. Höhere Prüfspannungen haben lediglich zur Folge, daß das Vorzünden früher einsetzt und das Nachzünden später abreißt. Da aber beim beschriebenen Verfahren und der zugehörigen Vorrichtung beide Vorgänge jeweils von den Abschirmelektroden übernommen werden, hat nunmehr die Wahl einer höheren Spannung keine Verschlechterung der Meßgenauigkeit zur Folge. Je höher aber die angelegte Spannung ist, desto sicherer können auch solche Isolationsfehler detektiert werden, die in der Isolationsschicht nicht vollständig bis zum Leiter reichen. Auch hier ergeben sich gegenüber dem Stand der Technik beachtliche Vorteile.

## Patentansprüche

1. Verfahren zum Überprüfen der Isolation von isolierten elektrischen Leitern, die wenigstens eine Ader haben, sowie zur Längenvermessung von Isolationsfehlern mit folgenden Verfahrensmerkmalen:
- Die Ader wird an mindestens zwei hintereinander liegenden Sonden, die jeweils Kondensatoren mit einem Leiterstück als Gegenpol bilden und von denen eine Sonde bevorzugt ist, vorbeibewegt,
- dabei sind die Sonden derart elektrisch aufgeladen, daß bei Fehlern in der Isolation der Ader der von der einzelnen Sonde und dem jeweiligen Leiterstück gebildete Kondensator von einem Durchschlagstrom kurzgeschlossen wird,
- beim Ein- und Auslaufen von Fehlern in der Isolation erfolgen bei der nicht bevorzugten Sonde jeweils nur kurzzeitige Überschläge als sogenanntes Funkenziehen, während an der bevorzugten Sonde die Überschläge genau in der Durchlaufzeit erfolgen, die der Länge des vorbeibewegten Isolationsfehlers entspricht,
- durch Erfassen der Überschläge an der bevorzugten Sonde und deren Auswertung werden ortsspezifische Signale in Korrelation mit dem Vorschub der Ader gewonnen,
- diese ortsspezifischen Signale geben eine unmittelbare Aussage über die Längenausdehnung des Isolationsfehlers.

2. Verfahren nach Anspruch 1, **dadurch gekennzeichnet,** daß die bevorzugte Sonde nur nach bzw. vor dem Funkenziehen einer oder mehrerer nicht bevorzugter Sonden mißt, die als Abschirmung zum Auffangen der Funken dienen.

3. Verfahren nach Anspruch 1, **dadurch gekennzeichnet,** daß das Funkenziehen der nicht bevorzugten Sonden ein Vorzünden und/oder ein Nachzünden realisiert.

4. Verfahren nach Anspruch 3, **dadurch gekennzeichnet,** daß der Durchschlagstrom der bevorzugten Sonde den auszuwertenden Zündvorgang realisiert.

5. Verfahren nach Anspruch 1, **dadurch gekennzeichnet,** daß die Ader mit Geschwindigkeiten bis zu 2000 m/min, bspw. 1000 m/min, an den Sonden vorbeibewegt wird.

6. Verfahren nach Anspruch 1, **dadurch gekennzeichnet,** daß bei einer Abzugsgeschwindigkeit von 1000 m/min Fehlerlängen von -0 bis 5 mm oder besser erfaßt werden.

7. Vorrichtung zur Erkennung und Klassifizierung von Isolationsfehlern in Adern mit mehreren an Hochspannung liegenden Elektroden, an denen die Ader berührungslos vorbeibewegt wird und die bei Auftreten eines Isolationsfehlers über einen Funken kurzgeschlossen werden, gemäß einem Verfahren nach Anspruch 1 oder einem der Ansprüche 2 bis 6, **gekennzeichnet durch** folgende Merkmale:
- Es ist genau eine Meßelektrode (HE) vorhanden, der wenigstens eine Abschirmelektrode (EE, AE) zugeordnet ist,
- die Meßelektrode (HE) und die Abschirmelektrode (EE, AE) bilden ein Elektrodensystem (EE, HE, AE), bei dem die Meßelektrode (HE) geometrisch und/oder elektrisch bevorzugt ist.

8. Vorrichtung nach Anspruch 7, **dadurch gekennzeichnet,** daß zumindest eine Abschirmelektrode (AE) hinter der Meßelektrode (ME) angeordnet ist.

9. Vorrichtung nach Anspruch 7 und Anspruch 8, **dadurch gekennzeichnet,** daß wenigstens zwei Abschirmelektroden (EE, AE) vorhanden sind, zwischen denen sich die Meßelektrode (ME) befindet.

10. Vorrichtung nach Anspruch 7, **dadurch gekennzeichnet,** daß das Elektrodensystem (EE, HE, AE) aus drei parallel angeordneten, gegeneinander isolierten Metallblechen (11 - 13) besteht.

11. Vorrichtung nach Anspruch 8, **dadurch gekennzeichnet,** daß die Metallbleche (11 - 13) je eine Fläche von etwa 20 mm x 20 mm, haben.

12. Vorrichtung nach Anspruch 8, **dadurch gekennzeichnet,** daß die Metallbleche (11 - 13) in geringem Abstand, insbesondere von weniger als 1 mm, voneinander isoliert befestigt sind.

13. Vorrichtung nach Anspruch 10, **dadurch gekennzeichnet,** daß das Metallblech (11) der Meßelektrode (HE) gegenüber den Metallblechen (12, 13) der Abschirmelektroden (EE, AE) hervorsteht.

14. Vorrichtung nach Anspruch 11, **dadurch gekennzeichnet,** daß das Meßelektrodenblech (11) etwa 1 mm gegenüber den äußeren Blechen (12, 13) hervorsteht.

15. Vorrichtung nach Anspruch 13 und 14, **dadurch gekennzeichnet,** daß die äußeren Bleche (12, 13) abgewinkelt ausgebildet sind.

16. Vorrichtung nach Anspruch 7, mit einer Hochspannungsquelle zum Anlegen von Hochspannung an das Elektrodensystem und zugehörigen Stromwandlern zur Erfassung von Kurzschlußströmen in den einzelnen Elektroden zugeordneten Leitungszweigen, **dadurch gekennzeichnet,** daß in den Leitungszweigen für die Abschirmelektroden (EE, AE) Widerstände (21) zur Schwächung des Kurzschlußstromes eingeschaltet sind.

17. Vorrichtung nach Anspruch 16, **dadurch gekennzeichnet,** daß die Leitungszweige für die Einzelelektroden (EE, HE, AE) des Elektrodensystems (10) parallel geschaltet sind.

18. Einrichtung nach Anspruch 7 und Anspruch 17, **dadurch gekennzeichnet,** daß in der gemeinsamen Hochspannungsleitung ein Vorwiderstand (24) eingeschaltet ist.

19. Einrichtung nach einem der Ansprüche 7 bis 18, **dadurch gekennzeichnet,** daß die Stromwandler in den einzelnen Zweigen Optokoppler (25, 27) zur potentialfreien Übertragung der Kurzschlußströme an ein Verstärkernetzwerk (30, 31) und eine zugehörige Auswerteeinrichtung (50) aufweisen.

20. Einrichtung nach einem der Ansprüche 7 bis 19, **dadurch gekennzeichnet,** daß die Auswerteeinrichtung einen Rechner, insbesondere einen Personalcomputer (50), umfaßt.
